# EUROPÄISCHE PATENTSCHRIFT

(11) **EP 1 939 950 B1**
(45) Veröffentlichungstag und Bekanntmachung des Hinweises auf die Patenterteilung: **20.02.2013**
(21) Anmeldenummer: 07120348.3
(22) Anmeldetag: 09.11.2007
(51) Int. Cl.: H01L 41/053, F02M 51/00, F02M 51/06

(54) **Piezoelektrischer Aktor**
Piezo-electric actuator
Actionneur piézoélectrique

(30) Priorität: 29.12.2006 DE 102006062561
(43) Veröffentlichungstag der Anmeldung: 02.07.2008
(73) Patentinhaber: ROBERT BOSCH GMBH, 70442 Stuttgart (DE)
(72) Erfinder: Schuett, Klaus-Volker, 73249 Wernau (DE); Holst, Marco, 70597 Stuttgart (Hoffeld) (DE); Cromme, Peter, 96050 Bamberg (DE); Kuhlmann, Kai, 96050 Bamberg (DE); Dirscherl, Florian, 96052 Bamberg (DE); Schuerg, Stefan, 71636 Ludwigsburg (DE); Klotz, Claudia, 96047 Bamberg (DE)

(56) Entgegenhaltungen:
- EP-A1- 1 574 702
- WO-A1-02/061856
- JP-A- 3 174 783
- US-A- 3 360 665

## Beschreibung

### Stand der Technik

Die Erfindung betrifft einen piezoelektrischen Aktor für ein Brennstoffeinspritzventil und ein Brennstoffeinspritzventil mit solch einem piezoelektrischen Aktor. Speziell betrifft die Erfindung das Gebiet der Injektoren für Brennstoffeinspritzanlagen von luftverdichtenden, selbstzündenden Brennkraftmaschinen.

Aus der WO 02/061856 A1 ist ein Verfahren zur Montage eines piezoelektrischen Aktors bekannt. Dabei wird der piezoelektrische Aktor innerhalb einer Hülse angeordnet, wobei ein gewisser Zwischenraum zwischen der Hülse und dem piezoelektrischen Aktor frei bleibt. Dieser Zwischenraum wird dann mit einem Füllmaterial gefüllt. Der auf diese Weise hergestellte piezoelektrische Aktor kann in einem Medium angeordnet werden, beispielsweise in Wasser oder in einem Brennstoff.

Der aus der WO 02/061856 A1 bekannte piezoelektrische Aktor hat den Nachteil, dass die Ausgestaltung mittels der Hülse aufwändig herzustellen ist, da zahlreiche Verfahrensschritte erforderlich sind, um das fertige Aktormodul zu schaffen. Ferner kann die Hülse das Dehnungsverhalten des piezoelektrischen Aktors und somit die Funktionsweise ungünstig beeinflussen.

JP 3-174783 offenbart ein laminiertes piezoelektrisches Element, dass zur Isolation eine Metallfolie aufweist, die mittels eines Klebemittels mit den Außenelektroden des piezoelektrischen Elements verbunden ist und einen Schrumpfschlauch, der die äußere Schicht der Isolation bildet.

### Offenbarung der Erfindung

Der erfindungsgemäße piezoelektrische Aktor mit den Merkmalen des Anspruchs 1 und das erfindungsgemäße Brennstoffeinspritzventil mit den Merkmalen des Anspruchs 6 haben den Vorteil, dass eine relativ kostengünstige Herstellung ermöglicht ist, wobei ein zuverlässiger Schutz gegenüber Medien gewährleistet ist, und dass insbesondere eine hohe Zuverlässigkeit und Funktionsfähigkeit gewährleistet ist.

Durch die in den Unteransprüchen aufgeführten Maßnahmen sind vorteilhafte Weiterbildungen des im Anspruch 1 angegebenen piezoelektrischen Aktors und des im Anspruch 6 angegebenen Brennstoffeinspritzventils möglich.

Vorteilhaft ist es, dass der Schrumpfschlauch den Aktorkörper umgibt und gegebenenfalls direkt an dem Aktorkörper anliegt, ohne dass eine direkte, kraftschlüssige Verbindung zwischen dem Schrumpfschlauch und dem Aktorkörper besteht. Dies hat den Vorteil, dass eine zuverlässige Umhüllung des Aktorkörpers zur Abdichtung gegenüber Brennstoffen gewährleistet ist, wobei lokale, mechanische Spannungsspitzen, die aus Polungsrissen des Aktorkörpers resultieren, nicht auf den Schrumpfschlauch übertragen werden. Der Schrumpfschlauch wird dadurch nur mit homogenen, dynamischen Wechseldehnungen des Aktorkörpers belastet, das heißt, dass eine Entkopplung von lokalen Effekten auf der Oberfläche des Aktorkörpers gegenüber dem Schrumpfschlauch gewährleistet ist.

Erfindungsgemäß ist ein Füllmitte vorhanden, das zwischen dem Schrumpfschlauch und dem Aktorkörper angeordnet ist. Durch das Füllmittel kann ein direkter Kontakt zwischen dem Schrumpfschlauch und dem Aktorkörper verhindert werden, wodurch eine Beeinflussung des Dehnungsverhaltens des Aktorkörpers im Betrieb des Brennstoffeinspritzventils verringert werden kann. Dabei ist es von Vorteil, dass das Füllmittel auf der Basis eines mit Fluor modifizierten Elastomers gebildet ist. Durch die elastische Ausgestaltung des Füllmittels besteht der Vorteil, dass der Einfluss auf das Dehnungsverhalten des Aktorkörpers weiter verringert ist. Durch die Modifikation des Elastomers mit Fluor ergibt sich dabei eine gute Medienstabilität sowie ein verbessertes Permeationsverhalten, um den Aktorkörper zuverlässig gegenüber Medien, wie beispielsweise Wasser enthaltenden Brennstoff, zu schützen. Das Füllmittel kann beispielsweise aus der Materialfamilie von Perfluorether-Elastomeren mit Perfluorether-Polymergerüst, das mit Siliconfunktionalitäten für die Vernetzung kombiniert ist, gewählt sein. Dabei umfasst diese Materialfamilie viele unterschiedliche Erscheinungsformen, von einer leicht fließenden Flüssigkeit bis hin zu gummiartigen Feststoffen, wobei das Füllmittel erfindungsgemäß im elastischen, festen Zustand eingesetzt ist.

Erfindungsgemäß ist das Füllmittel als thermoplastischer, aufgeschmolzener Füllmittelschlauch ausgebildet, der zwischen dem Schrumpfschlauch und dem Aktorkörper augeorduct ist. Dabei ist das Füllmittel zu Beginn des Schrumpfprozesses in Form eines in den Schrumpfschlauch eingebrachten Füllmittelschlauches ausgebildet, wobei ein Schmelzpunkt des Füllmittelschlauches niedriger ist als ein Schmelzpunkt des Schrumpfschlauches. Speziell kann der Schmelzpunkt des Füllmittelschlauches so gewählt sein, dass während des Schrumpfvorgangs des Schrumpfschlauches ein Aufschmelzen des Füllmittelschlauches erreicht wird. Der aufgeschmolzene Füllmittelschlauch bildet dann analog einem Schmelzkleber erfindungsgemäß die Verbindung zwischen dem Aktorkörper sowie gegebenenfalls dem Aktorkopf und dem Aktorfuß mit dem Schrumpfschlauch. Dies hat den Vorteil, dass eine hohe Medienbeständigkeit, insbesondere gegenüber Dieselkraftstoff, erreicht ist und dass kein zusätzlicher Klebstoff zur Verbindung der Bauteile erforderlich ist. Ferner ist eine einfache Montage ermöglicht, da der Füllmittelschlauch vor dem Aufbringen auf den Aktorkörper in den Schrumpfschlauch eingebracht werden kann.

### Kurze Beschreibung der Zeichnungen

Bevorzugte Ausführungsbeispiele der Erfindung sind in der nachfolgenden Beschreibung anhand der beigefügten Zeichnungen, in denen sich entsprechende Elemente mit übereinstimmenden Bezugszeichen versehen sind, näher erläutert. Es zeigt:
Fig. 1 ein Brennstoffeinspritzventil mit einem piezoelektrischen Aktor in einer schematischen Schnittdarstellung entsprechend einem ersten Ausführungsbeispiel der Erfindung;
Fig. 2 den in Fig. 1 mit II bezeichneten Ausschnitt eines piezoelektrischen Aktors entsprechend einem zweiten Ausführungsbeispiel der Erfindung während der Montage und
Fig. 3 den in Fig. 2 dargestellten Ausschnitt eines piezoelektrischen Aktors im montierten Zustand.

### Ausführungsformen der Erfindung

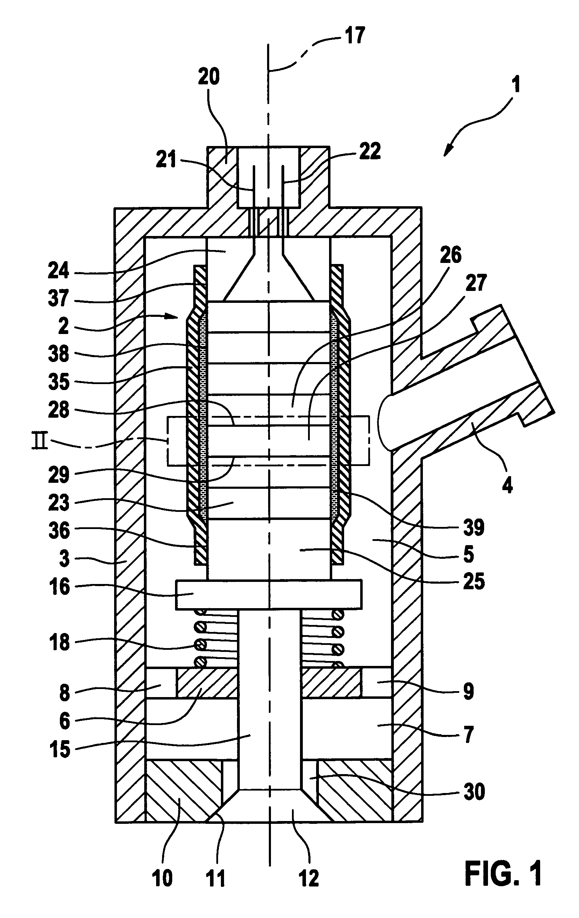

Fig. 1 zeigt ein Brennstoffeinspritzventil 1 mit einem piezoelektrischen Aktor 2. Das Brennstoffeinspritzventil 1 kann insbesondere als Injektor für Brennstoffeinspritzanlagen von luftverdichtenden, selbstzündenden Brennkraftmaschinen dienen. Ein bevorzugter Einsatz des Brennstoffeinspritzventils 1 besteht für eine Brennstoffeinspritzanlage mit einem Common-Rail, das Dieselbrennstoff unter hohem Druck zu mehreren Brennstoffeinspritzventilen 1 führt. Der piezoelektrische Aktor 2 eignet sich besonders für solch ein Brennstoffeinspritzventil 1 und auch für eine inverse Ansteuerung des piezoelektrischen Aktors 2. Das Brennstoffeinspritzventil 1 und der piezoelektrische Aktor 2 eignen sich jedoch auch für andere Anwendungsfälle.

Das Brennstoffeinspritzventil 1 weist ein Ventilgehäuse 3 und einen mit dem Ventilgehäuse 3 verbundenen Brennstoffeinlassstutzen 4 auf. An den Brennstoffeinlassstutzen 4 ist eine Brennstoffleitung anschließbar, um das Brennstoffeinspritzventil 1 über ein Common-Rail oder direkt mit einer Hochdruckpumpe zu verbinden. Über den Brennstoffeinlassstutzen 4 kann dann Brennstoff in einen im Inneren des Ventilgehäuses 3 vorgesehenen Aktorraum 5 eingeleitet werden, so dass sich im Betrieb des Brennstoffeinspritzventils 1 Brennstoff in dem Aktorraum 5, in dem auch der piezoelektrische Aktor 2 vorgesehen ist, befindet. Der Aktorraum 5 ist durch ein Gehäuseteil 6 von einem ebenfalls im Inneren des Ventilgehäuses 3 vorgesehenen Brennstoffraum 7 getrennt. In dem Gehäuseteil 6 sind dabei Durchlassöffnungen 8, 9 ausgestaltet, um den über den Brennstoffeinlassstutzen 4 in den Aktorraum 5 geführten Brennstoff in den Brennstoffraum 7 zu leiten.

Das Ventilgehäuse 3 ist mit einem Ventilsitzkörper 10 verbunden, an dem eine Ventilsitzfläche 11 ausgebildet ist. Die Ventilsitzfläche 11 wirkt mit einem Ventilschließkörper 12 zu einem Dichtsitz zusammen. Dabei ist der Ventilschließkörper 12 einstückig mit einer Ventilnadel 15 ausgebildet, über die der Ventilschließkörper 12 mit einer im Aktorraum 5 vorgesehenen Druckplatte 16 verbunden ist. Dabei ist die Ventilnadel 15 durch das Gehäuseteil 6 entlang einer Achse 17 des Brennstoffeinspritzventils 1 geführt. Ein Federelement 18, das einerseits an dem Gehäuseteil 6 und andererseits an der Druckplatte 16 anliegt, beaufschlagt den piezoelektrischen Aktor 2 mit einer Vorspannkraft, wobei durch die Beaufschlagung außerdem die Ventilnadel 15 mittels der Druckplatte 16 betätigt wird, so dass der zwischen dem Ventilschließkörper 12 und der Ventilsitzfläche 11 gebildete Dichtsitz geschlossen ist.

Außerdem weist das Ventilgehäuse 3 ein Anschlusselement 20 auf, um das Anschließen einer elektrischen Zuleitung an das Brennstoffeinspritzventil 1 zu ermöglichen. Die elektrische Zuleitung kann dabei mittels eines Steckers an elektrische Leitungen 21, 22 angeschlossen werden. Die elektrischen Leitungen 21, 22 sind durch das Gehäuse 3 und einen an einen Aktorkörper 23 des Aktors 2 angefügten Aktorfuß 24 an den Aktorkörper 23 geführt. An den Aktorkörper 23 des piezoelektrischen Aktors 2 ist ferner ein Aktorkopf 25 angefügt, über den der Aktorkörper 23 entgegen der Kraft des Federelements 18 auf die Druckplatte 16 einwirkt. Der piezoelektrische Aktor 2 weist in dem dargestellten Ausführungsbeispiel den Aktorkörper 23, den Aktorfuß 24 und den Aktorkopf 25 auf, so dass ein Aktormodul gebildet ist.

Der Aktorkörper 23 des piezoelektrischen Aktors 2 weist eine Vielzahl von keramischen Schichten 26, 27 und eine Vielzahl von zwischen den keramischen Schichten 26, 27 angeordneten Elektrodenschichten 28, 29 auf. Dabei sind in der Fig. 1 zur Vereinfachung der Darstellung nur die keramischen Schichten 26, 27 sowie die Elektrodenschichten 28, 29 gekennzeichnet. Die Elektrodenschichten 28, 29 sind abwechselnd mit der elektrischen Leitung 21 und der elektrischen Leitung 22 verbunden, so dass alternierend positive und negative Elektroden zwischen den keramischen Schichten 26, 27 vorgesehen sind.

Über die elektrischen Leitungen 21, 22 kann der piezoelektrische Aktor 2 geladen werden, wobei sich dieser in Richtung der Achse 17 ausdehnt, so dass der zwischen dem Ventilschließkörper 12 und der Ventilsitzfläche 11 ausgebildete Dichtsitz geöffnet wird. Dadurch kommt es zum Abspritzen von Brennstoff aus dem Brennstoffraum 7 über einen Ringspalt 30 und den geöffneten Dichtsitz. Beim Entladen des piezoelektrischen Aktors 2 zieht sich dieser wieder zusammen, so dass der zwischen dem Ventilschließkörper 12 und der Ventilsitzfläche 11 ausgebildete Dichtsitz wieder geschlossen ist.

Die Verbindung der elektrischen Leitungen 21, 22 mit den Elektrodenschichten 28, 29 kann durch innenliegende Elektrodenanbindungen erfolgen. Es können allerdings auch außenliegende Elektrodenanbindungen vorgesehen sein.

Der Aktorkörper 23 ist zwischen dem Aktorkopf 25 und dem Aktorfuß 24 angeordnet. Ferner ist ein Schrumpfschlauch 35 vorgesehen, der den Aktorkörper 23 umgibt. Der Schrumpfschlauch 35 umgibt außerdem teilweise den Aktorfuß 24 sowie teilweise den Aktorkopf 25. Der Schrumpfschlauch 35 ist einerseits mit dem Aktorkopf 25 und andererseits mit dem Aktorfuß 24 verbunden. Dabei kann einerseits zwischen dem Aktorkopf 25 und dem Schrumpfschlauch 35 an einer Verbindungsfläche 36 ein Klebstoff vorgesehen sein, um eine Klebstoffverbindung auszubilden. Ferner kann an einer Verbindungsfläche 37 zwischen dem Schrumpfschlauch 35 und dem Aktorfuß 24 ein weiterer Klebstoff zur Ausgestaltung einer weiteren Klebstoffverbindung vorgesehen sein. Somit kann der Schrumpfschlauch 35 sowohl mit dem Aktorkopf 25 als auch mit dem Aktorfuß 24 verbunden werden. Allerdings umgibt der Schrumpfschlauch 35 den Aktorkörper 23, ohne dass eine direkte Verbindung zwischen dem Schrumpfschlauch 35 und dem Aktorkörper 23 zustande kommt. Insbesondere ist keine kraftschlüssige Verbindung zwischen dem Schrumpfschlauch 35 und dem Aktorkörper 23 ausgebildet. Somit ist verhindert, dass lokale Spannungsspitzen, die aus Polungsrissen des Aktorkörpers 23 des piezoelektrischen Aktors 2 resultieren, auf den Schrumpfschlauch 35 übertragen werden, so dass der Schrumpfschlauch 35 nur mit der homogenen, dynamischen Wechseldehnung des Aktorkörpers 23 belastet wird. Dies stellt eine Entkopplung von lokalen Effekten auf einer Oberfläche 38 des Aktorkörpers 23 gegenüber dem Schrumpfschlauch 35 dar. Eine feste Anbindung zwischen dem Schrumpfschlauch 35 und dem Aktorkopf 25 beziehungsweise dem Aktorfuß 24 und der Einsatz von Klebstoff ist aber nicht notwendig.

In dem Beispiel, das in der Fig. 1 dargestellt ist, ist zwischen dem Aktorkörper 23 und dem Schrumpfschlauch 35 außerdem ein Füllmittel 39 vorgesehen. Das zwischen dem Schrumpfschlauch 35 und dem Aktorkörper 23 vorgesehene Füllmittel 39 ist auf der Basis eines mit Fluor modifizierten Elastomers gebildet. Das Füllmittel 39 kann zusätzlich auch teilweise auf den Aktorkopf 25 und teilweise auf den Aktorfuß 24 aufgebracht werden. Anschließend kann ein Vorvernetzen oder Vollvernetzen des Elastomers, das das Füllmittel 39 bildet, erfolgen. Dann wird der Schrumpfschlauch 35 über dem Aktorkörper 23 sowie teilweise über dem Aktorfuß 24 und dem Aktorkopf 25 platziert. Anschließend erfolgt ein Schrumpfen des Schrumpfschlauches 35 mit einem Schrumpfprozess, bei dem der Schrumpfschlauch 35 einem heißen, gasförmigen Medium, insbesondere heißer Luft, ausgesetzt wird. Dabei werden die Temperatur des gasförmigen Mediums und die Schrumpfgeschwindigkeit so eingestellt, dass mögliche Lufteinschlüsse innerhalb des Schrumpfschlauches 35 verhindert sind. Eine Schrumpfung mittels IR-Strahlung ist auch möglich. Nach Abschluss des Schrumpfprozesses kommt es gegebenenfalls zum weiteren Aushärten des Elastomers, das das Füllmittel 39 bildet. Dies kann auch von einer Nachtemperung des Schrumpfschlauches 35 begleitet werden.

Das Füllmittel 39 ist aus einem Elastomer gebildet, das mit Fluor modifiziert ist. Im Gegensatz zu Duroplasten verfügen Elastomere über einen molekularen Aufbau mit einer geringeren Dichte an chemischen Vernetzungsstellen und somit grundsätzlich über ein schlechteres Permeationsverhalten. Diese Nachteile können jedoch mit einem Elastomer, das mit Fluor modifiziert ist, ausgeglichen werden. Insbesondere weisen solche Elastomere eine hohe Widerstandsfähigkeit gegenüber Medien auf.

Je nach Anwendungsfall kann das Füllmittel 39 so ausgestaltet sein, dass eine relativ ausgeprägte Haftung des Elastomers an der Oberfläche 38 des Aktorkörpers 23 ausgebildet ist. Dann kann eine gewisse Quellung des Füllmittels 39 auf Grund eines eventuell eindringenden Brennstoffs erfolgen. Durch die Verbindung des Füllmittels 39 mit dem Aktorkörper 23 im Bereich der Oberfläche 38 wird die Desorption des eingedrungenen Brennstoffs verhindert, so dass sich nach einer gewissen Zeit ein Gleichgewichtszustand einstellt. Speziell bei medienbeständigen, schwach quellenden Elastomeren, die das Füllmittel 39 bilden können, wie zum Beispiel einem mit Fluor modifizierten Elastomer, verbleibt die Konzentration von leitfähigen Ionen in diesem Gleichgewichtszustand unter einem eher geringen Schwellwert, so dass die erforderliche Isolationswirkung des Füllmittels 39 gewährleistet ist. Durch den Schrumpfschlauch 35 wird neben der Permeationssperrwirkung ein zuverlässiger Schutz gegenüber mechanischer Beschädigung, beispielsweise auf Grund des durch den Aktorraum 5 strömenden Brennstoffs, erzielt. Ferner wird durch den Schrumpfschlauch 35 ein kompaktes Aktormodul ausgestaltet.

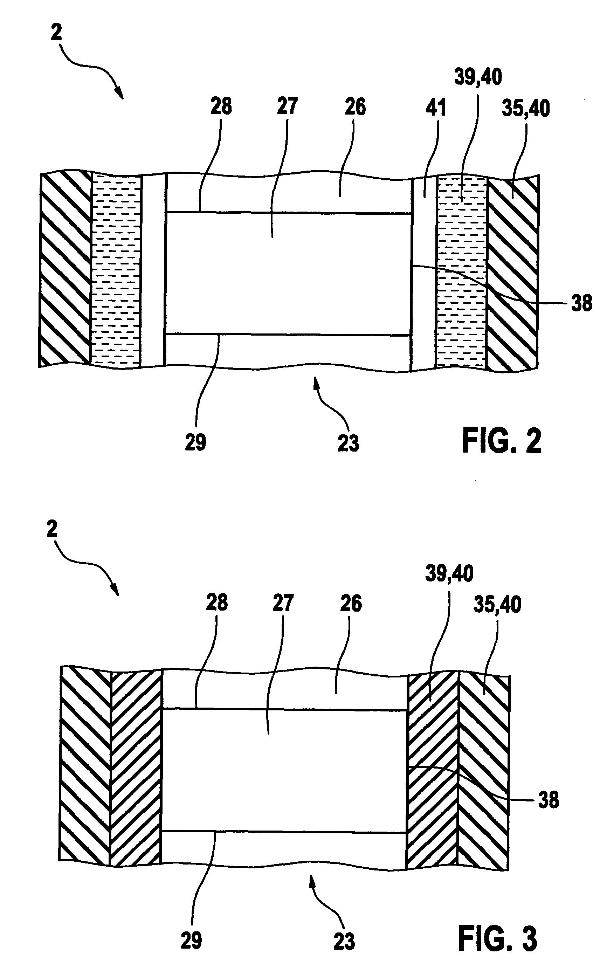

Fig. 2 zeigt den in Fig. 1 mit II bezeichneten Ausschnitt eines piezoelektrischen Aktors 2 eines Brennstoffeinspritzventils 1 entsprechend einem erfindungsgemäßen Ausführungsbeispiel während der Montage. In diesem Ausführungsbeispiel ist das Füllmittel 39 erfindungsgemäß als Füllmittelschlauch ausgebildet, der innerhalb des Schrumpfschlauches 35 vorgesehen ist. Somit bilden der Schrumpfschlauch 35 und der Füllmittelschlauch 39 einen Dualschrumpfschlauch 40. Der Dualschrumpfschlauch 40 kann beispielsweise aus einem langen Dualschrumpfschlauch in geeigneter Länge abgetrennt werden. Der Dualschrumpfschlauch 40 weist einen Innendurchmesser auf, der größer ist als ein Außendurchmesser des Aktorkörpers 23 sowie des Aktorfußes 24 und des Aktorkopfes 25. Während der Montage besteht deshalb ein gewisser Ringspalt 41 zwischen dem Schrumpfschlauch 35 und dem Aktorkörper 23, in dem sich Luft befindet. Das Füllmittel 39 des Füllmittelschlauches ist aus einem thermoplastischen Material gebildet, das einen niedrigeren Schmelzpunkt hat als das Material des Schrumpfschlauches 35. Speziell liegt eine Schmelztemperatur des Füllmittels 39 in einem Bereich, der für den Schrumpfprozess beim Schrumpfen des Schrumpfschlauches 35 eingestellt ist. Während des Schrumpfprozesses schrumpft der Dualschlauch 40 auf Grund der Schrumpfung des Schrumpfschlauches 35 zusammen. Die Temperatur und die Schrumpfgeschwindigkeit sind dabei so gewählt, dass die Luft aus dem Ringspalt 41 vollständig verdrängt wird, so dass Lufteinschlüsse zwischen dem Schrumpfschlauch 35 und dem Aktorkörper 23, dem Aktorfuß 24 sowie dem Aktorkopf 25 verhindert sind. Während des Schrumpfprozesses kommt es außerdem zum Aufschmelzen des Füllmittels 39, so dass das Füllmittel 39 entsprechend einem Schmelzkleber die Verbindung zwischen dem Aktorkörper 23 und dem Schrumpfschlauch 35 ausgebildet. Dabei wird auch die Verbindung zwischen dem Schrumpfschlauch 35 und dem Aktorfuß 24 sowie dem Aktorkopf 25 gebildet. Ein zusätzlicher Klebstoff ist dabei nicht erforderlich.

Fig. 3 zeigt den in Fig. 2 dargestellten Ausschnitt eines piezoelektrischen Aktors 2 eines Brennstoffeinspritzventils 1 im montierten Zustand. Dabei ist der Ringspalt 41, der in der Fig. 2 dargestellt ist, vollständig eliminiert, so dass das angeschmolzene oder aufgeschmolzene Füllmittel 39, das wieder erstarrt ist, direkt an den Aktorkörper 23 angrenzt. Auf Grund der elastischen Ausgestaltung des Füllmittels 39 kann dabei auch eine gewisse kraftschlüssige Verbindung zwischen dem Füllmittel 39 und der Oberfläche 38 des Aktorkörpers 23 bestehen.

Die Erfindung ist nicht auf das beschriebene Ausführungsbeispiele beschränkt.

## Patentansprüche

1. Piezoelektrischer Aktor (2), insbesondere Aktor für Brennstoffeinspritzventile mit einem Aktorkörper (23), der eine Vielzahl von keramischen Schichten (26, 27) und eine Vielzahl von zwischen den keramischen Schichten (26, 27) angeordneten Elektrodenschichten (28, 29) aufweist, einem Aktorkopf (25) und einem Aktorfuß (24), wobei der Aktorkörper (23) zwischen dem Aktorkopf (25) und dem Aktorfuß (24) angeordnet ist, wobei ein Schrumpfschlauch (35) Vorhanden ist, der den Aktorkörper (23) umgibt, der Schrumpfschlauch (35) einerseits mit dem Aktorkopf (25) und andererseits mit dem Aktorfuß (24) verbunden ist und der Schrumpfschlauch (35) zumindest mittelbar an dem Aktorkörper (23) anliegt,
**dadurch gekennzeichnet,**
**dass** zwischen dem Schrumpfschlauch (35) und dem Aktorkörper (23) ein thermoplastischer, aufgeschmolzener Füllmittelschlauch (39) angeorduct ist, wobei ein Schmelzpunkt des Füllmittelschlauches niedriger ist als ein Schmelzpunkt des Schrumpfschlauches (35), so dass der Füllmittelschlauch eine Verbindung zwischen dem Aktorkörper (23) sowie dem Aktorkopf (25) und dem Aktorfuß (24) mit dem Schrumpfschlauch (35) bildet.

2. Piezoelektrischer Aktor nach Anspruch 1,
**dadurch gekennzeichnet,**
**dass** der Füllmittel Schlauch (39) auf der Basis eines mit Fluor modifizierten Elastomers ausgebildet ist.

3. Piezoelektrischer Aktor nach Anspruch 2,
**dadurch gekennzeichnet,**
**dass** der Füllmittel schlauch (39) durch ein ausgehärtetes Elastomer gebildet ist.

4. Piezoelektrischer Aktor nach einem der Ansprüche 1 bis 3,
**dadurch gekennzeichnet,**
**dass** der Schrumpfschlauch (35) mit dem Aktorkopf (25) und dem Aktorfuß (24) durch Klebstoffverbindungen oder mittels Kraftschluss verbunden ist.

5. Piezoelektrischer Aktor nach einem der Ansprüche 1 bis 4,
**dadurch gekennzeichnet,**
**dass** der Schrumpfschlauch (35) den Aktorkörper (23) zumindest im Wesentlichen ohne Lufteinschlüsse umgibt.

6. Brennstoffeinspritzventil (1), insbesondere Injektor für Brennstoffeinspritzanlagen von luftverdichtenden, selbstzündenden Brennkraftmaschinen, mit einem piezoelektrischen Aktor (2) nach einem der Ansprüche 1 bis 5 und einem von dem Aktor (2) betätigbaren Ventilschließkörper (12), der mit einer Ventilsitzfläche (11) zu einem Dichtsitz zusammenwirkt.

## Claims

1. Piezo-electric actuator (2), in particular actuator for fuel injection valves, with an actuator body (23) which has a multiplicity of ceramic layers (26, 27) and a multiplicity of electrode layers (28, 29) arranged between the ceramic layers (26, 27), with an actuator head (25) and with an actuator foot (24), the actuator body (23) being arranged between the actuator head (25) and the actuator foot (24), a shrink-on hose (35) being present which surrounds the actuator body (23), the shrink-on hose (35) being connected, on the one hand, to the actuator head (25) and, on the other hand, to the actuator foot (24), and the shrink-on hose (35) bearing at least indirectly against the actuator body (23), **characterized in that** a thermoplastic melted-on filler hose (39) is arranged between the shrink-on hose (35) and the actuator body (23), a melting point of the filler hose being lower than a melting point of the shrink-on hose (35), so that the filler hose forms a connection between the actuator body (23) and the actuator head (25) and the actuator foot (24) with the shrink-on hose (35).

2. Piezo-electric actuator according to Claim 1, **characterized in that** the filler hose (39) is formed on the basis of a fluorine-modified elastomer.

3. Piezo-electric actuator according to Claim 2, **characterized in that** the filler hose (39) is formed by cured elastomer.

4. Piezo-electric actuator according to one of Claims 1 to 3, **characterized in that** the shrink-on hose (35) is connected to the actuator body (25) and to the actuator foot (24) by means of adhesive bonds or non-positively.

5. Piezo-electric actuator according to one of Claims 1 to 4, **characterized in that** the shrink-on hose (35) surrounds the actuator body (23) at least essentially without air inclusions.

6. Fuel injection valve (1), in particular injector for fuel injection systems of air-compression autoignition internal combustion engines, with a piezo-electric actuator (2) according to one of Claims 1 to 5 and with a valve-closing body (12) which is actuable by the actuator (2) and which cooperates with a valve-seat surface (11) to form a sealing seat.

## Revendications

1. Actionneur piézoélectrique (2), en particulier actionneur pour soupape d'injection de carburant, qui présente
un corps (23) d'actionneur doté de plusieurs couches céramiques (26, 27) et de plusieurs couches d'électrodes (28, 29) disposées entre les couches céramiques (26, 27),
une tête (25) d'actionneur et un pied (24) d'actionneur,
le corps (23) d'actionneur étant disposé entre la tête (25) d'actionneur et le pied (24) d'actionneur,
un tuyau flexible rétractable (35) étant prévu pour entourer le corps (23) d'actionneur,
le tuyau flexible rétractable (35) étant relié d'une part à la tête (25) d'actionneur et d'autre part au pied (24) d'actionneur et le tuyau flexible rétractable (35) reposant au moins indirectement sur le corps (23) d'actionneur,
**caractérisé en ce que**
un tuyau flexible (39) thermoplastique fondu d'agent de charge est disposé entre le tuyau flexible rétractable (35) et le corps (23) d'actionneur et
**en ce que** le point de fusion du tuyau flexible d'agent de charge est plus bas que le point de fusion du tuyau flexible rétractable (35), de telle sorte que le tuyau flexible d'agent de charge forme avec le tuyau flexible rétractable (35) une liaison entre le corps (23) d'actionneur, la tête (25) d'actionneur et le pied (24) d'actionneur.

2. Actionneur piézoélectrique selon la revendication 1, **caractérisé en ce que** le tuyau flexible (39) d'agent de charge est formé à base d'un élastomère modifié par fluor.

3. Actionneur piézoélectrique selon la revendication 2, **caractérisé en ce que** le tuyau flexible (39) d'agent de charge est formé d'un élastomère durci.

4. Actionneur piézoélectrique selon l'une des revendications 1 à 3, **caractérisé en ce que** le tuyau flexible rétractable (35) est relié à la tête (25) d'actionneur et au pied (24) d'actionneur par des liaisons adhésives ou en correspondance mécanique.

5. Actionneur piézoélectrique selon l'une des revendications 1 à 4, **caractérisé en ce que** le tuyau flexible rétractable (35) entoure le corps (23) d'actionneur au moins essentiellement sans inclusions d'air.

6. Soupape (1) d'injection de carburant, en particulier injecteur pour installation d'injection de carburant de moteurs à combustion interne à auto-allumage et compression d'air, la soupape présentant un actionneur piézoélectrique (2) selon l'une des revendications 1 à 5 et un corps (12) de fermeture de soupape qui peut être actionné par l'actionneur (2) et qui coopère avec une surface (11) de siège de soupape pour former un siège étanche.
